# EUROPÄISCHE PATENTSCHRIFT

(11) **EP 3 234 621 B1**
(45) Veröffentlichungstag und Bekanntmachung des Hinweises auf die Patenterteilung: **29.05.2019**
(21) Anmeldenummer: 15801179.1
(22) Anmeldetag: 27.11.2015
(51) Int. Cl.: G01R 31/36, G01R 35/00, H01M 10/42, H01M 10/48

(54) **TESTVORRICHTUNG ZUR ÜBERPRÜFUNG EINES BATTERIE-STEUERGERÄTES ODER EINER BATTERIE UND VERFAHREN ZUR TESTUNG EINES BATTERIE-STEUERGERÄTES ODER EINER BATTERIE**
TEST APPARATUS FOR CHECKING A BATTERY CONTROL DEVICE OR A BATTERY, AND METHOD FOR TESTING A BATTERY CONTROL DEVICE OR A BATTERY
DISPOSITIF DE TEST POUR CONTRÔLER UNE UNITÉ DE COMMANDE DE BATTERIE OU UNE BATTERIE ET PROCÉDÉ POUR TESTER UNE UNITÉ DE COMMANDE DE BATTERIE OU UNE BATTERIE

(30) Priorität: 17.12.2014 DE 102014226190
(43) Veröffentlichungstag der Anmeldung: 25.10.2017
(73) Patentinhaber: Robert Bosch GmbH, 70442 Stuttgart (DE)
(72) Erfinder: MATTES, Bernhard, 74343 Sachsenheim (DE); HOENIG, Guenter, 71254 Ditzingen (DE); THOMAS, Robert, 70469 Stuttgart (DE); ROTH, Manuel, 75365 Calw (DE)
(86) Internationale Anmeldenummer: PCT/EP2015/077886
(87) Internationale Veröffentlichungsnummer: WO 2016/096371

(56) Entgegenhaltungen:
- CN-A- 103 941 210
- DE-A1-102007 007 268
- DE-A1-102011 054 370
- "Zellspannungsemulation: Spannung garantiert Hochgenaue Zellspannungsemulation mit dem dSPACE HIL-Simulator", INTERNET CITATION, 1. März 2010 (2010-03-01), Seiten 40-45, XP002679139, Gefunden im Internet: URL:http://www.dspace.com/shared/data/pdf/ 2011/dSPACE-Magazine-2010-03_Batterie_D.pd f [gefunden am 2012-06-27]
- WAI CHUNG LEE ET AL: "Development of a Hardware-in-the-Loop Simulation System for Testing Cell Balancing Circuits", IEEE TRANSACTIONS ON POWER ELECTRONICS, INSTITUTE OF ELECTRICAL AND ELECTRONICS ENGINEERS, USA, Bd. 28, Nr. 12, 1. Dezember 2013 (2013-12-01), Seiten 5949-5959, XP011514361, ISSN: 0885-8993, DOI: 10.1109/TPEL.2013.2256799
- Sajjad Haidar ET AL: "Use a photoelectric-FET optocoupler as a linear voltage-controlled potentiometer", , 19. Januar 2012 (2012-01-19), XP055255546, Gefunden im Internet: URL:http://www.edn.com/Pdf/ViewPdf?content ItemId=4368893 [gefunden am 2016-03-04]

## Beschreibung

Die Erfindung betrifft eine Testvorrichtung zur Überprüfung eines Batterie-Steuergerätes oder einer Batterie und ein Verfahren zur Testung eines Batterie-Steuergerätes oder einer Batterie.

### Stand der Technik

In der Kraftfahrzeugindustrie gewinnen elektrische Antriebe, insbesondere in Elektro- oder Hybridfahrzeugen, zunehmend an Bedeutung. Diese elektrischen Antriebe verfügen über eine Batterie. Die Batterie wird von einem Batterie-Steuergerät überwacht. Vor dem Einbau in Elektro- oder Hybridfahrzeugen muss die Batterie und auch das Batterie-Steuergerät erprobt werden.

In der Praxis werden automatisierte Test- und Prüfstände für die Testfallgenerierung, die Prüfstandskonfiguration, die Testdurchführung und für die Testauswertung eingesetzt. Dazu zählt der HIL-Standard, eine englische Abkürzung für Hardware-in-the-loop-Standard. Bei einem HIL-Testsystem wird mindestens eine reale Komponente an einem Simulator angeschlossen.

Jedoch sind die Vorrichtungen bei einem HIL-Standard komplex aufgebaut, schwer, voluminös und nicht genügend mobil für einen Batterie-Elektronik-Test im Feld.

Ein Beispiel für den Stand der Technik kann dem folgenden Artikel entnommen werden: dSPACE GmbH. *Spannung garantiert*, [entnommen am 2012-06-27]. URL: https:// www.dspace.com/shared/data/pdf/2011/dSPACE-Magazine-2010-03_Batterie_D.pdf. Ein weiteres Beispiel für den Stand der Technik findet sich in der Patentschrift DE 10 2011 054370 A1 (dSPACE GmbH).

Die Verwendung eines Opto-Feldeffekttransistors als steuerbares Potentiometer ist in folgendem Artikel offenbart: SAJJAD, Haidar. *Use a photoelectric-FET optocoupler as a linear voltage-controlled potentiometer*, [entnommen am 2016-03-04]. URL: http://www.edn.com/Pdf/ViewPdf?contentItemId=4368893.

Es ist somit Aufgabe der Erfindung eine Testvorrichtung zur Überprüfung eines Batterie-Steuergerätes zur Verfügung zu stellen, welches über einen einfachen Aufbau verfügt und auf einfache Weise sämtliche Zellen einer simulierten oder realen Batterie überprüfen kann.

Die Lösung der Aufgabe erfolgt durch eine erfindungsgemäße Testvorrichtung, sowie mit einem erfindungsgemäßen Verfahren. Bevorzugte Ausgestaltungen der Erfindung sind in den Unteransprüchen und der nachfolgenden Beschreibung angegeben, die jeweils einzeln oder in Kombination einen Aspekt der Erfindung darstellen können.

### Offenbarung der Erfindung

Erfindungsgemäß umfasst eine Testvorrichtung zur Überprüfung eines Batterie-Steuergerätes oder zur Überprüfung einer Batterie mit mindestens einer Zelle, einen Batteriesimulator zur Simulation einer Spannung mindestens einer Zelle einer simulierten Batterie zur Vorgabe an das Batterie-Steuergerät, wobei das Batterie-Steuergerät oder die Batterie über einen als zentraler Bus ausgeführte Schiene mit einem Auswertemodul verbunden ist zur Bearbeitung und Überprüfung der Spannung, Temperaturen und weiterer Größen einer ausgewählten Zelle, wobei die ausgewählte Zelle des Batteriesimulators für das Batterie-Steuergerät oder die ausgewählte Zelle der Batterie über ein Trennstellenmodul auswählbar ist.

Je nach Testmodus der Testvorrichtung kann in der Testvorrichtung eine Batterie simuliert werden zum Testen eines Batterie-Steuergerätes oder eine reale Batterie überprüft werden.

Durch einen derartigen Aufbau kann eine einfache, mobile Testvorrichtung zur Überprüfung eines Batterie-Steuergerätes zur Verfügung gestellt werden. Das Batterie-Steuergerät kann ein Battery Control and Supervision Unit, abgekürzt BCSU sein. Das Batterie-Steuergerät kann mindestens eine Überwachungsvorrichtung, insbesondere mindestens einen CSC-Chip aufweisen. Die Abkürzung CSC steht für den englischen Begriff Cell Supervision Circuit. Ein Cell Supervision Circuit CSC überwacht die einzelnen Zellen und sorgt für deren Zusammenspiel. Damit die Zellen nicht dauerhaft unterschiedlich stark belastet werden, gleicht der CSC den Ladezustand aller Zellen in der Batterie aneinander an. Durch die Verwendung eines Batteriesimulators können die Versorgungsspannungen für die Überwachungsvorrichtung des Batterie-Steuergeräts zur Verfügung gestellt werden. Dabei kann der Batteriesimulator einzelne Zellen einer Batterie simulieren und die entsprechenden Messgrößen wie Versorgungspannungen an die Überwachungsvorrichtung weiterleiten, so dass die Überwachungsvorrichtung eine Überprüfung und Bearbeitung der simulierten Zellen vornehmen kann. Weiterhin kann über den Batteriesimulator die Versorgungsspannung und Versorgungsströme der Überwachungsvorrichtung gemessen werden und über das Auswertemodul bearbeitet werden. Der Batteriesimulator wird jedoch nicht verwendet sondern abgeschaltet, wenn eine Batterie in der Testvorrichtung getestet werden soll.

Die als zentraler Bus ausgeführte Schiene ist insbesondere eine zentrale Spannungsschiene. Der Begriff Bus beschreibt ein System zur Übertragung von Spannung, Temperatur, Daten und weiteren Größen zwischen mehreren Teilnehmern über einen gemeinsamen Übertragungsweg, bei dem die Teilnehmer nicht an der Übertragung zwischen anderen Teilnehmern beteiligt sind. Der Begriff zentrale Spannungsschiene beschreibt ein sogenanntes Rail umfassend Rail+ und Rail- an welche die einzelnen Zellen des Batteriesimulators oder der Batterie angeschlossen werden können und auf diese Weise mit dem Auswertemodul verbunden werden um von dem Auswertemodul bearbeitet und überprüft zu werden. Dabei können die einzelnen Zellen des Batteriesimulators oder der Batterie über ein Trennstellenmodul mit einzelnen Trennstufen ausgewählt werden, damit eine Operation durch das Auswertemodul vorgenommen werden kann. Über das Trennstellenmodul kann das Auswertemodul mit einer ausgewählten Zelle des Batteriesimulators oder der Batterie verbinden, so dass das Zellspannungspotential identisch mit der Spannungsschiene, insbesondere mit dem Rail+ und dem Rail- Potential ist.

Durch das Auswertemodul können unterschiedliche Varianten zur Verstellung, Überwachung und Bearbeitung einer beliebigen über das Trennstellenmodul ausgewählten Zelle eines Batteriesimulators oder einer Batterie durchgeführt werden. Zur Durchführung kann das Auswertemodul nach einem fließenden Grundkonzept, auf Englisch floating ground concept, arbeiten. Dabei werden sämtliche Daten einer ausgewählten Zelle durch das Auswertemodul erfasst, kontrolliert und manipuliert. Entscheidend bei dem Konzept ist, dass die Rückmeldung mit einem Soll-Ist-Wert Vergleich verglichen werden kann und die Zelle entsprechend der Werte korrekt angesteuert werden kann. Der Bezugspunkt kann dabei an dem Minuspol der ausgewählten Zelle liegen. Dabei kann das Auswertemodul bei einem Batterie-Steuergerätetest eine Zellspannungsvorgabe mit Spannungsrückmeldung durchführen und ein Test des Ausgleichsstroms für die ausgewählte Zelle mit Strom, beispielsweise 100 mA, und eine Strommessung durchführen. Bei einem Batterietest kann das Auswertemodul eine Messung der Zellspannungen und den Ausgleichsstrom mit Stromvorgaben testen. Zusätzlich können über den Bus weitere Größen beispielsweise eine Temperatur durch entsprechende Erweiterung über Schalter erfasst werden Auf diese Weise kann eine Testvorrichtung zur Überprüfung eines Batterie-Steuergerätes oder zur Überprüfung einer Batterie zur Verfügung gestellt werden, welches über einen einfachen Aufbau verfügt und auf einfache Weise sämtliche Zellen einer simulierten oder realen Batterie überprüfen kann. Insbesondere kann die Testvorrichtung über ein Spannungsversorgungsmodul mit einer vorgebbaren Spannung versorgt werden. Das Spannungsversorgungsmodul kann insbesondere eine Spannung für das Batterie-Steuergerät zur Verfügung stellen, beispielsweise 48V. Weiterhin kann das Spannungsversorgungsmodul eine allgemeine Spannungsversorgung für die restlichen Digitalmodule der Testvorrichtung zur Verfügung stellen, beispielsweise eine Spannung von 5V.

In einer bevorzugten Ausführungsform ist über ein Steuermodul die Bearbeitung und Überprüfung des Auswertemoduls koordinierbar. Das Steuermodul kann über einen Zentralrechner, insbesondere einen Mikrokontroller, verfügen. Der Zentralrechner dient als Steuer- und Kommunikationseinheit und kann von allen Modulen der Testvorrichtung Messwerte erhalten und an die Module Befehle zur Bearbeitung versenden. Auf diese Weise kann jeweils eine eigene Recheneinheit für jedes einzelne Modul eingespart werden. Die Kommunikation des Auswertemoduls mit dem Zentralrechner kann über Optokoppler erfolgen. Der Zentralrechner kann als Koordinator dienen und den Testablauf festlegen. Beispielsweise kann der Istwert den das Batterie-Steuergerät ermittelt an den Zentralrechner über CAN, eine englische Abkürzung für Controller Area Network, übermittelt werden. CAN ist ein serielles Bussystem und gehört zu den Feldbussen.

Erfindungsgemäß ist vorgesehen, dass über ein Widerstandsnetzwerk mit mindestens einem steuerbaren Opto-Feldeffekttransistor eine Spannung einer ausgewählten Zelle des Batterie-Simulators oder der Batterie änderbar ist. Insbesondere kann durch den mindestens einen steuerbaren Opto-Feldeffekttransistor eine selektive Änderung eines Zellnachbildungswiderstandes durch Ausnutzung einer Widerstandskennlinie des Opto-Feldeffekttransistors erfolgen. Mit Hilfe des Opto-Feldeffekttransistors, auf Englisch abgekürzt Opto Mos FETs, kann auf einfache Weise eine Zellspannungsverstellung einer ausgewählten Zelle erfolgen. Über eine Rückmeldung über den Zentralrechner kann eine Regelung auf den gewünschten Widerstand und damit den Spannungswert für jede beliebige Zelle vorgenommen werden. Das Widerstandsnetzwerk kann mit Hilfe eines Konstantstrommoduls mit Strom versorgt werden. Durch das Widerstandsnetzwerk kann eine Zellspannung einer ausgewählten Zelle individuell verändert werden. Der Stromwert und damit auch die Versorgungsspannung für das Batteriesteuergerät kann durch den Zentralrechner des Steuermoduls vorgegeben werden. Die Zellspannung kann über einen Widerstandsabfall an Widerständen in Verbindung mit einer Stromeinspeisung erfolgen. Bei einem Batterietest ist das Widerstandsnetzwerk von dem Konstantstrommodul abgekoppelt. Stattdessen erhält das Widerstandsnetzwerk die Spannung von der Batterie.

Es ist bevorzugt, dass über das Auswertemodul ein Wert für einen Ausgleichsstrom in Laderichtung der Zelle oder in Entladerichtung der Zelle vorgebbar ist, wobei durch das Auswertemodul der Ausgleichsstrom für jede Zelle des Batterie-simulators für das Batterie-Steuergerät oder für jede Zelle der Batterie unabhängig von einer benachbarten Zelle steuerbar ist. Der Ausgleichsstrom, auf Englisch balancing current, sorgt in einer Batterie, insbesondere in einem Akkupack eines Akkumulators, dass die Zellen alle eine gleichmäßige Spannung aufweisen. Batterien bestehen zur Erhöhung der Nennspannung in der Regel aus mehreren in Reihe geschalteten Einzelzellen oder Zellblöcken. Fertigungsbedingt gibt es Schwankungen in der Kapazität und im Innenwiderstand dieser Zellen. Im praktischen Einsatz von mehrzelligen, seriell verschalteten Batterien führt dieser Umstand dazu, dass die Zellen unterschiedlich entladen und geladen werden und kritische Ladezustände einnehmen können. Dabei führen die unterschiedlichen Spannungslagen der einzelnen Zellen innerhalb eines seriellen Verbundes bei der Entladung zur Gefahr der Tiefentladung einzelner Zellen. In Reihe geschaltete Zellen erreichen beim gemeinsamen Laden auch nicht die gleiche Lade-Endspannung, was zu Überladungen einzelner Zellen führen kann. Dadurch, dass das Auswertemodul den Ausgleichstrom für jede Zelle des Batteriesimulators oder der Batteriezelle unabhängig von einer benachbarten Zelle steuern kann, können unterschiedliche Balancing-Methoden, also Ausgleichsmethoden, mit Stromvorgaben durch die Verstelleinrichtung realisiert werden. Beispielsweise kann die Verstelleinrichtung gemäß der Vorgabe des Batterie-Steuergerätes den Ausgleichsstrom an die nachfolgende Zelle weiterleiten, so dass der Ausgleichsstrom immer durch die gesamte Batterie oder durch den gesamten Batteriesimulator fließt. Weiterhin kann eine selektive Ausgleichsmethode angewandt werden, so dass der Stroms aus einer vorbestimmten Zelle entnommen werden kann und direkt in andere ausgewählte Zelle weitergeleitet werden, ohne dass benachbarte Zellen oder andere Zellen bei dem Ausgleichsvorgang involviert sind.

In einer bevorzugten Ausführungsform umfasst das Auswertemodul einen Kondensator zur Zwischenspeicherung mit einer Spannung für den Ausgleichsstrom. Auf diese Weise kann die Ausgleichsfunktion erweitert werden. Dadurch kann selektiv ein Ausgleich für jede Zelle unabhängig von der benachbarten Zelle vorgenommen werden. Über einen Kondensator kann eine zusätzlich Aufladung oder Entladung erfolgen. Beispielsweise kann eine zusätzliche Aufladung über einen DC/DC Wandler auf ein höheres Spannungsniveau erfolgen, um eine höhere Speicherfähigkeit zu erhalten und eine hohe Spannung zum Ausgleichen zu erhalten.

Vorzugsweise ist das Auswertemodul mit einem Temperaturmodul verbindbar zur Erfassung mindestens einer von dem Batterie-Steuergerät gemessenen Temperatur oder einer Temperatur mindestens einer Zelle der Batterie. Die Zelltemperatur kann dabei entweder über einzelne Module, insbesondere Temperatursensoren, erfolgen, welche jeweils einzeln die Temperaturen jeder Zelle messen und an das Auswertemodul weiterleiten. Weiterhin kann eine Temperaturnachbildung einer Widerstandsänderung entsprechen, welche über Opto-Feldeffekttransistoren zur Zellspannungsnachbildung erfolgen. Dabei erfolgt immer eine Rückmeldung des aktuellen Wertes der Opto-Feldeffekttransistoren an das Auswertemodul.

Es ist bevorzugt, dass die Testvorrichtung eine Matrix aufweist zur Zuweisung einer Versorgungsspannung für die Überwachungsvorrichtung. Auf diese Weise können mit Hilfe der Überwachungsvorrichtung beliebige Zellverteilungskonfigurationen ermöglicht werden. Mit Hilfe einer Matrix kann eine Entkopplung der Stromversorgung der CSC Chips in dem Batterie-Steuergerät ermöglicht werden, wodurch keine Rückwirkung eines Entnahmestroms auf die Zellspannungen erfolgen kann. Die CSC Versorgungsspannungen und die Versorgungsströme können gemessen werden und an den Zentralrechner übermittelt werden. Vorzugsweise ist das Auswertemodul eine Vorgabe von beliebigen Temperaturen für ausgewählte Zellen als Spannungs- oder Widerstandswerte mit Rückmeldung ermöglichbar. Insbesondere kann das Auswertemodul über ein Relais eine Auswahlverbindung zum Temperaturmodul aufbauen. Eine Auswahl mit Temperaturvorgabe kann dabei derart erfolgen, dass die Auswerteeinheit für eine ausgewählte Zelle eine Temperaturvorgabe über veränderbare Spannungs- oder Widerstandswerte vornimmt, während die nichtausgewählten Zellen über einen Festwiderstand eine Spannung vorgegeben bekommen. Durch die Rückmeldung der Werte kann die Auswerteinheit die Temperatur für die ausgewählte Zelle durch eine Spannungs- oder Widerstandsänderung einstellen. Dabei kann die Auswerteinheit mit einem zugehörigen Spannungsniveau angesteuert werden.

In einer bevorzugten Ausführungsform umfasst die Testvorrichtung eine Kommunikationseinheit zur Kommunikation mit einem externen Bedienelement. Die Kommunikationseinheit kann dabei eine Bluetooth-Schnittstelle, ein Wireless-Lan Netzwerk oder ein externer CAN sein. Ein Wireless LAN Netzwerk bezeichnet ein lokales Funknetz. Mit Hilfe des externen Bedienelementes kann die Testvorrichtung global gesteuert werden. Auf diese Weise kann das Testsystem kompakt ausgestaltet werden, denn es ist nicht nötig externe Bedienelemente fest mit der Testvorrichtung zu verbinden. Weiterhin kann die Testvorrichtung beabstandet von dem externen Bedienelement angeordnet sein, so dass beispielsweise das Bedienelement und die Testvorrichtung in zwei verschiedenen Räumlichkeiten angeordnet sein können. Mit Hilfe des externen Bedienelementes können die Daten der Testvorrichtung auch ausgewertet werden.

Weiterhin betrifft die Erfindung ein Verfahren zur Testung eines Batterie-Steuergerätes oder zur Testung einer Batterie in einer Testvorrichtung, die wie oben beschrieben weitergebildet oder ausgebildet ist, umfassend folgende Schritte:
- Anschließen eines Batterie-Steuergerätes an die Testvorrichtung oder Anschließen einer Batterie mit mindestens einer Zelle an die Testvorrichtung; und
- Bearbeiten oder Überprüfen des Batterie-Steuergerätes oder der Batterie über ein Auswertemodul der Testvorrichtung.

Auf diese Weise kann ein Verfahren mit einer Testvorrichtung zur Überprüfung eines Batterie-Steuergerätes oder zur Überprüfung einer Batterie zur Verfügung gestellt werden, bei dem die Testvorrichtung über einen einfachen Aufbau verfügt und auf einfache Weise sämtliche Zellen einer simulierten oder realen Batterie überprüfen kann.

In einer bevorzugten Ausführungsform umfasst das Verfahren folgenden Schritt:
- Einstellen eines Ausgleichstroms für mindestens eine ausgewählte Zelle des Batteriesimulators oder der Batterie unabhängig von einer benachbarten Zelle.

Nachfolgend wird die Erfindung unter Bezugnahme auf die anliegenden Zeichnungen anhand bevorzugter Ausführungsbeispiele exemplarisch erläutert, wobei die nachfolgend dargestellten Merkmale sowohl jeweils einzeln als auch in Kombination einen Aspekt der Erfindung darstellen können. Es zeigen:

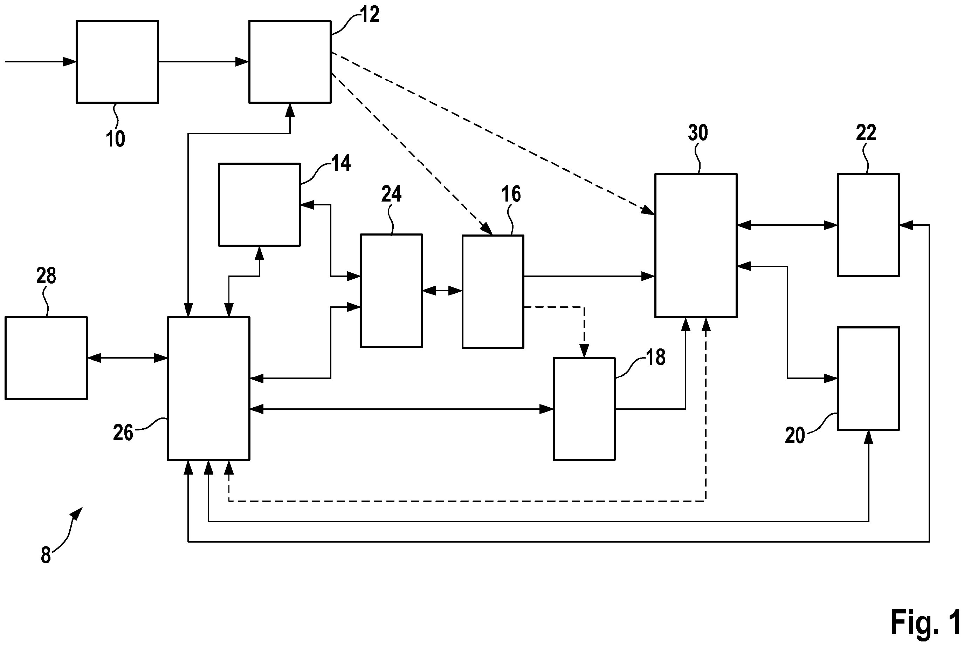

Fig. 1 eine schematische Zeichnung einer Testvorrichtung

Fig. 1 zeigt eine schematische Zeichnung einer Testvorrichtung 8 an dem ein Testmodul 30 angeschlossen ist. Die Testvorrichtung 8 ist in Fig. 1 als eine schematische Modulzeichnung dargestellt. Die einzelnen Module des Testmoduls sind als Blöcke dargestellt. Das Testmodul 30 soll entweder ein Batterie-Steuergerät oder eine Batterie darstellen, welche durch die Testvorrichtung 8 getestet werden soll. Die Testvorrichtung 8 umfasst ein Auswertemodul 14, ein Widerstandsnetzwerk 16, einen Batteriesimulator 18, ein Temperaturmodul 20, ein Relaismodul 22, ein Trennstellenmodul 24 und ein Steuermodul 26. Weiterhin umfasst das Testmodul eine nicht dargestellte zentrale Spannungsschiene ein sogenanntes Rail umfassend Rail+ und Rail- an welche die einzelnen Zellen des Batteriesimulators oder der Batterie angeschlossen werden können und auf diese Weise mit dem Auswertemodul 14 verbunden sind um von dem Auswertemodul 14 bearbeitet und überprüft zu werden.

Die Testvorrichtung 8 wird mit Hilfe einer Spannungsversorgung 10 und einem Konstantstrommodul 12 mit Strom versorgt. Das Konstantstrommodul 12 wird über das Spannungsversorgungsmodul 10 mit einer Spannung und mit Strom versorgt. Dies wird mit einem Pfeil von dem Spannungsversorgungsmodul 10 zu dem Konstantstrommodul 12 angedeutet. Das Modul 12 liefert ebenfalls die Versorgungsspannung für das Batteriesteuergerät 30.

Das Spannungsversorgungsmodul 10 wird mit Hilfe eines externen Netzgerätes mit einer Spannung von 7 Volt bis 19 Volt versorgt. Dies wird mit einem Pfeil angedeutet. Mit Hilfe des Spannungsversorgungsmoduls 10 wird ein Batterie-Steuergerät mit einer Basisspannung gemäß eines Batteriesimulators mit einer von dem Steuermodul 26 vorgegebenen Batteriepackspannung versorgt. Weiterhin versorgt das Spannungsversorgungsmodul 10 die restlichen Digitalmodule mit einer Spannung von 5V. Die Spannungsversorgung 10 kann auch eine Spannung von 1,5 V für Optokoppler zur Durchschaltung von Signalen des Trennstellenmoduls 24 bereitstellen.

Das Konstantstrommodul 12 erzeugt einen Konstantstrom für das Widerstandsnetzwerk 16. Weiterhin kann mit Hilfe des Konstantstrommoduls 12 der Gesamtstrom eines Batterie-Steuergerätes gemessen werden. Das Konstantstrommodul 12 wird durch einen Zentralrechner des Steuermoduls 26 gesteuert. Das Konstantstrommodul 12 kann ein Umschaltmodul umfassen um verschiedene Testmodi mit der Testvorrichtung 8 durchführen zu können. Die verschiedenen Testmodi sind reiner Testmodus für das Batterie-Steuergerät durch eine Konstantstromeinspeisung oder ein Testmodus für die Batterie, wobei in diesem Fall das Widerstandsnetzwerk 16 und das Testmodul 30 von der Spannungsversorgung durch das Konstantstrommodul 12 abgetrennt wird. Die Beziehungen des Konstantstrommoduls 12 mit dem Widerstandsnetzwerk 16, der Verstelleinrichtung 26 und dem Batterie-Steuergerät 30 sind als Pfeile dargestellt. Der gestrichelte Pfeil zwischen dem Konstantstrommodul 12 und dem Testmodul 30 sollen verdeutlichen, dass nur bei einem Batterie-Steuergerätetest das Konstantstrommodul 12 eine Spannung dem Widerstandsnetzwerk 16 und dem Testmodul 30 zur Verfügung stellt. Bei einem Batterietest stellen die einzelnen Zellen der Batterie die Spannung zur Verfügung.

Es lassen sich sowohl das Batteriesteuergerät als auch gleichzeitig die Batterie anschließen über getrennte Stecker mit einer Umschaltung über ein Relais zur Abschaltung von Widerstandsnetzwerk 16.

Das Auswertemodul 14 umfasst verschiedene unterschiedliche Varianten zur Verstellung und Überwachung einer beliebigen über das Trennstellenmodul 24 ausgewählten Zelle eines Batteriesimulators oder Batterie. Wesentlich zur Durchführung ist das floating ground Konzept zur Erfassung, Kontrolle und Manipulation der ausgewählten Zelle. Das Auswertemodul 14 kann nach einem erdpotentialfreien Konzept, Englisch floating ground concept, arbeiten. Dabei werden sämtliche Daten einer vorgegebenen Zelle durch das Auswertemodul 14 erfasst, kontrolliert und manipuliert. Entscheidend bei dem Konzept ist, dass die Rückmeldung mit einem Soll-Ist-Wert Vergleich verglichen werden kann und die Zelle entsprechend der Werte korrekt angesteuert werden kann. Der Bezugspunkt kann dabei an dem Minuspol der ausgewählten Zelle liegen. Die Kommunikation des Auswertemoduls 14 mit dem Zentralrechner des Steuermoduls 26 erfolgt über Optokoppler. Der Zentralrechner des Steuermoduls 26 dient als Koordinator und legt den Testablauf fest. Der Istwert den das Testmodul 30 ermittelt wird an den Zentralrechner über CAN übermittelt. Dies ist in der Fig. 1 als ein gestrichelter Pfeil zwischen dem Steuermodul 26 und dem Testmodul 30 dargestellt. Das Auswertemodul 14 ermöglicht bei einem Batterie-Steuergerätetest eine Zellspannungsvorgabe mit Spannungsrückmeldung und ein Testausgleich einer Zelle mit einem Strom, beispielsweise mit 100mA, und die Strommessung. Bei einem Batterietest ermöglicht das Auswertemodul 14 die Messung der einzelnen Zellen der Batterie und unterschiedliche Balancing-Methoden mit Stromvorgabe. Entweder wird der Strom an die nachfolgende Zelle weitergeleitet, so dass der Strom durch alle Zellen der Batterie fließt oder es erfolgt ein selektives Balancing, so dass der Strom aus einer vorbestimmten Zelle entnommen wird und in eine weitere vorgebebene Zelle eingespeist wird. Mit Hilfe des Auswertemoduls 14 erfolgt die Messung des Stroms einer Zelle sowohl bei der Entnahme als auch bei der Einspeisung. In einer alternativen Ausführungsform weist das Auswertemodul 14 einen Mikrokontroller zur Durchführung der Operationen auf. Mit Hilfe eines Serial Peripheral Interface, kurz SPI, wird das Auswertemodul 14 mit dem Steuermodul 26 verbunden. Auf diese Weise werden die Schnittstellen zwischen dem Auswertemodul 14 und dem Steuermodul 26 reduziert, weiterhin erfolgt eine Auswertung der Messwerte direkt in dem Auswertemodul 14. In einer weiteren Ausführungsform des Auswertemoduls 14 weist das Auswertemodul 14 einen Kondensator zur Zwischenspeicherung einer Spannung auf. Damit lässt sich die Balancing Funktion erweitern, wodurch sich selektiv das Balancing für jede Zelle unabhängig von der benachbarten Zelle vornehmen lässt. Weiterhin erfolgt durch den Kondensator zusätzlich eine Aufladung und Entladung. Die Aufladung erfolgt durch einen DC/DC Wandler auf ein höheres Niveau, um eine höhere Speicherfähigkeit zu erhalten und eine hohe Spannung zur Balancing zu erhalten. Die Beziehungen zwischen dem Auswertemodul 14, dem Steuermodul 26 und dem Trennstellenmodul 24 sind in Fig. 1 als Doppelpfeile dargestellt.

Das Widerstandsnetzwerk 16 wird über das Konstantstrommodul 12 mit Strom versorgt. Hierdurch lässt sich eine Spannung einer Zelle eines Batteriesimulators oder einer Batterie verändern ohne die Spannungen der anderen Zellen zu verändern. Der Stromwert selbst lässt sich durch einen Zentralrechner des Steuermoduls 26 vorgeben und überwachen. Die Spannung für die einzelnen Zellen lässt sich über einen Spannungsabfall an Widerständen in Verbindung mit einer Stromeinspeisung in dem Widerstandsnetzwerk 16 erzeugen. Die Widerstandsteuerung erfolgt zwischen zwei benachbarten Anschlüssen in dem Widerstandsnetzwerk 16, um eine Zellspannung zu reduzieren. Die Änderung erfolgt dabei über Optokoppler. Eine Spannungsrückmeldung erfolgt mittels des Auswertemoduls 14 mit Selektion der zu betrachtenden Zelle über das Trennstellenmodul 24. Die Beziehungen des Widerstandsnetzwerkes 16 mit dem Konstantstrommodul 12, dem Batteriesimulator 18 und dem Trennstellenmodul 24 sind in Fig. 1 als Pfeile dargestellt.

Der Batteriesimulator 18 ermöglicht eine Auswahl von Spannungen vom Widerstandsnetzwerk 16 mit nachgeschalteten Optokopplern für die Versorgung der CSC Chips im Batterie-Steuergerät. Dadurch ergibt sich keine Rückwirkung des Entnahmestroms auf die Zellspannung. Die CSC Versorgungsspannung und Versorgungsströme werden gemessen und an den Zentralrechner im Steuermodul 26 übermittelt. Die Spannungsversorgung für die CSC Chips erfolgt in dem Batteriesimulator 18 über eine Matrix mit Crosspointstruktur. Dabei stellen horizontale Leitungen die Zellspannungen und die kreuzenden vertikalen Leitungen die Versorgung der CSC Chips dar. Weiterhin umfasst der Batteriesimulator 18 einen Operationsverstärker zur Versorgung der CSC-Chips. Die Beziehungen des Batteriesimulators 18 mit dem Widerstandsnetzwerk 16, dem Steuermodul 26 und dem Testmodul 30 sind in Fig. 1 als Pfeile dargestellt.

Das Temperaturmodul 20 dient zur Temperaturnachbildung des Testmoduls 30. Dabei sind zwei alternative Ausführungsformen möglich. In einer ersten Ausführungsform erfolgt die Temperaturerfassung mit einzelnen Modulen, welche jeweils einzeln die Temperaturen jeder Zelle messen und an das Steuermodul 26 weiterleiten. In einer weiteren Ausführungsform erfolgt eine Temperaturnachbildung über eine Widerstandsänderung, welche über Opto-Feldeffekttransistoren zur Zellspannungsnachbildung erfolgt. Dabei erfolgt immer eine Rückmeldung des aktuellen Wertes eines Operationsverstärkers an das Steuermodul 26. Die Beziehungen des Temperaturmoduls 20 mit dem Testmodul 30 und dem Steuermodul 26 sind in Fig. 1 als Doppelpfeile dargestellt.

Mit Hilfe des Relaismoduls 22 werden das Starten des Motors des Kraftfahrzeugs und die Aufladung der Batterie des Kraftfahrzeugs simuliert. Die Signale für die Simulation kommen entweder über einen Hardwareschalter, über einen Mikrokontroller mit den Signalen Starten und Aufladen oder direkt von einem angeschlossen Fahrzeug. Weiterhin kann das Relaismodul 22 ein Relais umfassen, welches die Nachbildung von Starten und Aufladen über eine LED Anzeige anzeigt und eine Rückmeldung an das Steuermodul 26 weiterleitet. Die Beziehungen des Relaismoduls 22 mit dem Testmodul 30 und dem Steuermodul 26 sind in Fig. 1 als Doppelpfeil dargestellt.

Das Trennstellenmodul 24 umfasst einzelne Trennstufen und ist zwischen dem Auswertemodul 14 und dem Widerstandsnetzwerk 16 angeordnet. Über das Trennstellenmodul 24 lässt sich jede beliebige Zelle eines Batteriesimulators oder einer Batterie mit dem Auswertemodul 14 verbinden, so dass das Zellspannungspotential identisch zu dem Rail+ und Rail- Potential ist. Die restlichen Zellspannungen werden dadurch nicht beeinflusst. Die Beziehungen zwischen dem Trennstellenmodul 24, dem Auswertemodul 14, dem Widerstandsnetzwerk 16 und dem Steuermodul 26 sind als Doppelpfeile dargestellt.

Das Steuermodul 26 umfasst einen Zentralrechner. Der Zentralrechner ist ein Mikrokontroller. Mit Hilfe des Steuermoduls 26 erfolgt die Steuerung, Überwachung und die Kommunikation der Testvorrichtung 8 mit den anderen Modulen. Das Steuermodul 26 dient als Steuer- und Kommunikationseinheit der Testvorrichtung 8. Das Steuermodul 26 weist eine Kommunikationseinheit auf zur Kommunikation mit dem externen Bedienelement 28 über WLAN oder Bluetooth. Die Beziehungen zwischen dem Steuermodul 26, dem Konstantstrommodul 12, dem Auswertemodul 14, dem Batteriesimulator 18, dem Temperaturmodul 20, dem Relaismodul 22, dem Trennstellenmodul 24, dem externen Bedienmodul 28 und dem Testmodul 30 sind in Fig. 1 als Pfeile dargestellt.

Das externe Bedienelement 28 kann ein Tablet PC, ein externer Computer, ein Smartphone oder ein anderes Bedienelement sein, welches sich drahtlos über WLAN oder Bluetooth mit dem Steuermodul 16 verbinden kann.

Das Testmodul 30 ist entweder das zu testende Batterie-Steuergerät oder die zu testende Batterie.

## Patentansprüche

1. Testvorrichtung zur Überprüfung eines Batterie-Steuergerätes oder zur Überprüfung einer Batterie mit mindestens einer Zelle, umfassend
einen Batteriesimulator (18) zur Simulation einer Spannung mindestens einer Zelle einer simulierten Batterie zur Vorgabe an das Batterie-Steuergerät, wobei das Batterie-Steuergerät oder die Batterie über eine als zentraler Bus ausgeführte Schiene mit einem Auswertemodul (14) verbunden ist zur Bearbeitung und Überprüfung der Spannung einer ausgewählten Zelle, wobei die ausgewählte Zelle des Batteriesimulators (18) für das Batterie-Steuergerät oder die ausgewählte Zelle der Batterie über ein Trennstellenmodul (24) auswählbar ist, **dadurch gekennzeichnet, dass** über ein Widerstandsnetzwerk (16) mit mindestens einem steuerbaren Opto-Feldeffekttransistor eine Spannung einer ausgewählten Zelle des Batterie-Simulators oder der Batterie änderbar ist.

2. Testvorrichtung nach Anspruch 1, **dadurch gekennzeichnet, dass** über ein Steuermodul (26) die Bearbeitung und Überprüfung des Auswertemoduls (14) koordinierbar ist.

3. Testvorrichtung nach einem der vorherigen Ansprüche, **dadurch gekennzeichnet, dass** über das Auswertemodul (14) ein Wert für einen Ausgleichsstrom in Laderichtung der Zelle oder in Entladerichtung der Zelle vorgebbar ist, wobei durch das Auswertemodul (14) der Ausgleichsstrom für jede Zelle des Batteriesimulators (18) für das Batterie-Steuergerät oder für jede Zelle der Batterie unabhängig von einer benachbarten Zelle steuerbar ist.

4. Testvorrichtung nach Anspruch 3, **dadurch gekennzeichnet, dass** das Auswertemodul (14) einen Kondensator umfasst zur Zwischenspeicherung einer Spannung für den Ausgleichsstrom.

5. Testvorrichtung nach einem der Ansprüche 2 bis 4, **dadurch gekennzeichnet, dass** das Auswertemodul (14) mit einem Temperaturmodul (20) verbindbar ist zur Erfassung mindestens einer von dem Batterie-Steuergerät gemessenen Temperatur oder einer Temperatur mindestens einer Zelle der Batterie.

6. Testvorrichtung nach einem der vorherigen Ansprüche, **dadurch gekennzeichnet, dass** der Batteriesimulator (18) eine Matrix aufweist zur Zuweisung einer Versorgungsspannung für die Überwachungsvorrichtung des Batterie-Steuergerätes.

7. Testvorrichtung nach einem der vorherigen Ansprüche, **dadurch gekennzeichnet, dass** durch das Auswertemodul (14) eine Vorgabe von beliebigen Temperaturen für ausgewählte Zellen als Spannungs- oder Widerstandswerte mit Rückmeldung ermöglichbar ist.

8. Testvorrichtung nach Anspruch 2, **dadurch gekennzeichnet, dass** das Steuermodul (26) eine Kommunikationseinheit umfasst zur Kommunikation mit einem externen Bedienelement.

9. Verfahren zur Testung eines Batterie-Steuergerätes oder zur Testung einer Batterie in einer Testvorrichtung nach einem der Ansprüche 1 bis 8, umfassend folgende Schritte:
- Anschließen eines Batterie-Steuergerätes an die Testvorrichtung oder Anschließen einer Batterie mit mindestens einer Zelle an die Testvorrichtung; und
- Bearbeiten oder Überprüfen des Batterie-Steuergerätes oder der Batterie über ein Auswertemodul (14) der Testvorrichtung.

10. Verfahren nach Anspruch 9, weiterhin umfassend folgenden Schritt:
- Einstellen eines Ausgleichstroms für mindestens eine ausgewählte Zelle des Batteriesimulators (18) oder der Batterie unabhängig von einer benachbarten Zelle.

## Claims

1. Test apparatus for checking a battery control device or for checking a battery having at least one cell, comprising a battery simulator (18) for simulating a voltage of at least one cell of a simulated battery for specification to the battery control device, wherein the battery control device or the battery is connected to an evaluation module (14) via a rail designed as a central bus in order to process and check the voltage of a selected cell, wherein the selected cell of the battery simulator (18) for the battery control device or the selected cell of the battery can be selected via an isolating module (24), **characterized in that** a voltage of a selected cell of the battery simulator or the battery can be changed via a resistor network (16) having at least one controllable optical field effect transistor.

2. Test apparatus according to Claim 1, **characterized in that** the processing and checking by the evaluation module (14) can be coordinated via a control module (26) .

3. Test apparatus according to one of the preceding claims, **characterized in that** a value for a balancing current in the charging direction of the cell or in the discharging direction of the cell can be specified via the evaluation module (14), wherein the evaluation module (14) can control the balancing current for each cell of the battery simulator (18) for the battery control device or for each cell of the battery, independently of an adjacent cell.

4. Test apparatus according to Claim 3, **characterized in that** the evaluation module (14) comprises a capacitor for the intermediate storage of a voltage for the balancing current.

5. Test apparatus according to one of Claims 2 to 4, **characterized in that** the evaluation module (14) can be connected to a temperature module (20) for detecting at least one temperature measured by the battery control device or a temperature of at least one cell of the battery.

6. Test apparatus according to one of the preceding claims, **characterized in that** the battery simulator (18) has a matrix for assigning a supply voltage for the monitoring device of the battery control device.

7. Test apparatus according to one of the preceding claims, **characterized in that** a specification of any temperatures for selected cells as voltage or resistance values with feedback is made possible by the evaluation module (14).

8. Test apparatus according to Claim 2, **characterized in that** the control module (26) comprises a communication unit for communication with an external operating element.

9. Method for testing a battery control device or for testing a battery in a test apparatus according to one of Claims 1 to 8, including the following steps of:
- connecting a battery control device to the test apparatus or connecting a battery having at least one cell to the test apparatus; and
- processing or checking the battery control device or the battery via an evaluation module (14) of the test apparatus.

10. Method according to Claim 9, further comprising the following step of:
- adjusting a balancing current for at least one selected cell of the battery simulator (18) or the battery, independently of an adjacent cell.

## Revendications

1. Dispositif de test destiné à contr583ôler une unité de commande de batterie ou à contrôler une batterie dotée d'au moins un élément, comprenant
un simulateur de batterie (18) destiné à simuler une tension d'au moins un élément d'une batterie simulée, afin de la spécifier à l'unité de commande de batterie, dans lequel l'unité de commande de batterie ou la batterie est reliée, par l'intermédiaire d'un rail réalisé sous la forme d'un bus central, à un module d'évaluation (14) destiné à traiter et contrôler la tension d'un élément sélectionné, dans lequel l'élément sélectionné du simulateur de batterie (18), destiné à l'unité de commande de batterie, ou l'élément sélectionné de la batterie peut être sélectionné par un module de point de séparation (24),
**caractérisé en ce qu'**une tension d'un élément sélectionné du simulateur de batterie ou de la batterie peut être modifiée par l'intermédiaire d'un réseau de résistances (16) comportant au moins un transistor à effet de champ optique pouvant être commandé.

2. Dispositif de test selon la revendication 1, **caractérisé en ce que** le traitement et le contrôle du module d'évaluation (14) peuvent être coordonnés par l'intermédiaire d'un module de commande (26).

3. Dispositif de test selon l'une des revendications précédentes, **caractérisé en ce qu'**une valeur d'un courant de compensation dans la direction de charge de l'élément ou dans la direction de décharge de l'élément peut être spécifiée par le module d'évaluation (14), dans lequel le courant de compensation de chaque élément du simulateur de batterie (18) pour l'unité de commande de batterie ou pour chaque élément de la batterie peut être commandé par le module d'évaluation (14) indépendamment d'un élément adjacent.

4. Dispositif de test selon la revendication 3, **caractérisé en ce que** le module d'évaluation (14) comprend un condensateur destiné au stockage intermédiaire d'une tension pour le courant de compensation.

5. Dispositif de test selon l'une des revendications 2 à 4, **caractérisé en ce que** le module d'évaluation (14) peut être relié à un module de température (20) destiné à détecter au moins une température mesurée par l'unité de commande de batterie ou une température d'au moins un élément de la batterie.

6. Dispositif de test selon l'une des revendications précédentes, **caractérisé en ce que** le simulateur de batterie (18) comporte une matrice destinée à affecter une tension d'alimentation pour le dispositif de surveillance de l'unité de commande de batterie.

7. Dispositif de test selon l'une des revendications précédentes, **caractérisé en ce que** le module d'évaluation (14) permet de spécifier avec rétroaction des températures arbitraires pour des cellules sélectionnées en tant que valeurs de tension ou de résistance.

8. Dispositif de test selon la revendication 2, **caractérisé en ce que** le module de commande (26) comprend une unité de communication permettant une communication avec un élément de commande externe.

9. Procédé pour tester une unité de commande de batterie ou pour tester une batterie dans un dispositif de test selon l'une des revendications 1 à 8, comprenant les étapes consistant à :
- connecter une unité de commande de batterie au dispositif de test ou connecter une batterie comportant au moins un élément au dispositif de test ; et
- traiter ou contrôler l'unité de commande de batterie ou la batterie par l'intermédiaire d'un module d'évaluation (14) du dispositif de test.

10. Procédé selon la revendication 9, comprenant en outre l'étape consistant à :
- régler un courant de compensation destiné à au moins un élément sélectionné du simulateur de batterie (18) ou de la batterie indépendamment d'un élément adjacent.
